# EUROPEAN PATENT SPECIFICATION

(11) **EP 2 333 859 B1**
(45) Date of publication and mention of the grant of the patent: **13.09.2017**
(21) Application number: 09015017.8
(22) Date of filing: 03.12.2009
(51) Int. Cl.: H01L 51/56

(54) **A method for forming an organic light emitting diode**
Verfahren zum Bilden einer organischen lichtemittierenden Diode
Procédé de formation d'une diode électroluminescente organique

(43) Date of publication of application: 15.06.2011
(73) Proprietor: Novaled GmbH, 01307 Dresden (DE)
(72) Inventor: Lessmann, Rudolf Dr., 01307 Dresden (DE); Blochwitz-Nimoth, Jan Dr., 01097 Dresden (DE); Jobert, Pierre Paul, 38500 Voiron (FR)
(74) Representative: Bittner, Thomas L.

(56) References cited:
- EP-A2- 1 489 671
- WO-A2-2007/004115
- JP-A- 2009 266 451
- US-A1- 2005 255 715
- US-A1- 2005 270 464

## Description

The invention relates to a method for forming an organic light emitting diode (OLED), in particular a top emitting organic light emitting diode.

### Background of invention

Organic light-emitting diodes have undergone a very rapid development in recent years. In particular, efficiencies of more than 100 lumen / W were successfully obtained for white-emitting light-emitting diodes. As also the lifetime of these systems has grown very quickly and, in the meantime, values of 10,000 hours for some material systems have even been significantly exceeded; organic light-emitting diodes also appear interesting for applications in lighting systems. The essential advantages of the organic light-emitting diodes are the high efficiency, the possibility of realizing very thin, large area, surface lighting units.

The conventional structural arrangement of organic light emitting diodes comprises a transparent substrate, glass in most cases, which is coated with a transparent anode that is frequently formed from indium tin oxide (ITO). Onto this, active organic layers are deposited and, subsequently and additionally, a metallic cathode for electrical contacting is deposited. If some volts are applied between the metallic cathode and the transparent anode, the light-emitting diode emits the light through the substrate (bottom emission). Another variation is the top emitting OLED, in which the top electrode (anode or cathode) is transparent. Top emitting OLEDs can be constructed under a variety of substrates, for example metal substrates, Si-wafers, display backplanes, printec circuit boards (PCB), or even transparent substrates coated with a reflective layer, which reflective layer can be the bottom electrode itself. Exemplary documents concerning OLEDs are US 4,539,507, WO 90/13148, US 2004/0,062,949, US 2004/0,251,816, and US 2007/0,051,946.

Several techniques are known to pattern OLEDs, to connect top emitting OLEDs in series, or in parallel, or even mixed connections. These methods make strong use of patterning such as photolithography, shadow mask for vapor deposition, or others.

It is also known that laser can be used to ablate OLEDs to generate patterns or to isolate short circuited areas. In all cases, the laser is used to ablate at least one conducting electrode to break the electrical connection.

Several different approaches have been formulated to create large area, homogeneous OLED lighting devices. The main problem is the current distribution across the surface. Usually the electrodes of the OLED are also the current distribution layers (electrical bus), or an extra conductive layer is deposited over the electrode, which has to be thin if transparency is required. For large areas, the resistance of these thin conductive layers is too high, since the current required for a large area OLED is very high. The resistance is the cause of the strong inhomogeneity in light emission and the device degradation.

Some approaches for homogeneity correction is the use of additional current supply lines, for example a metal grid deposited in connection to both electrodes. This grid lowers the resistance, but also slightly decreases the active area since it is not transparent. The metal grid also has a limited thickness, limiting again the maximum current that can be supplied to the OLED without loosing homogeneity. For higher currents, a denser grid is necessary, which decreases the efficiency of the whole device. Sometimes a grid is also not desired, because it again depreciates the homogeneity.

Another source of efficiency loss is the power lost by the electrical supply connections. The electrical connections are formed on the substrate and provide an electrical connection outside of the encapsulating region to the electrode itself, which is inside the encapsulated region. The distance of this thin film electrical connection is several cm, in the best cases, several mm. The film can be larger, but not much thicker, because thicker layers would be not practical to deposit and would cause problem on the encapsulation.

The standard electrical connections used in OLEDs cause not only a big loss in power transmission but their resistance and the large current cause considerable heating of the substrate, which does further depreciate the operational lifetime of the device.

The known methods used for patterning OLEDs are complex processes; patterning the several layers of an OLED requires several steps which increase complexity, and decreases the quality yield and the production throughput.

The electrical interconnection of the conductive layers forming the electrodes, especially the top electrode, and their respective current supply layers (electrical bus) is conventionally made by pattering the organic semiconducting layer (OSL). The OSL is patterned in such a way that some regions of a bottom conductive layer are not covered of it, and the deposition of the top conductive layer does form an electrical contact to the bottom conductive layer due to the direct contact.

Especially for large area OLEDs, such as for lighting application, it is of highest interest to simplify the production of OLEDs and avoid patterning steps. One exemplary critical application is the production of OLEDs in a roll-to-roll process, here it is necessary to move the mask with the roll, which is highly undesired.

The document JP 2009 266451 A discloses a method for manufacturing a display. A lower electrode and an auxiliary electrode are formed in a pattern on a substrate. The lower electrode and the auxiliary electrode are insulated from each other. Organic layers are formed on the electrodes. The auxiliary electrode is irradiated with a laser beam to remove the organic layer on the auxiliary electrode. Finally, an upper electrode is formed on the organic layers and connected to the auxiliary electrode.

A method of making a top emitting OLED device is disclosed in document EP 1 489 671 A2. The method comprises the step of provided a substrate on which a lower electrode and an upper electrode bus are formed. An organic electroluminescent layer is formed on the lower electrode and the upper electrode bus. Parts of the organic electroluminescent layer are removed from at least portions of the upper electrode bus by laser radiation. An upper electrode is deposited on the organic electroluminescent layer so that the upper electrode is in electrical contact with the upper electrode bus.

WO 2007/004115 discloses an OLED device having a substrate, first and second electrically conductive layers and an organic functional layer in between. The first conductive layer is connected to electrically isolated segments in the second conductive layer by vias which are formed by laser irradiation.

### Summary of the invention

It is the object of the invention to provide improved techniques for forming electrical connections in an organic electrical device, especially in a top emitting organic light emitting diode. It is also desired to be able to produce more complex electrical interconnections in an organic light emitting device in an easier manner.

According to the invention, a method of forming a top emitting organic light emitting diode is provided, as defined in claim 1. The invention overcomes problems of the prior art, by providing a method to create electrical interconnection through an organic semiconducting layer. The organic semiconducting layer may be provided as single organic layer or a stack of organic sub-layers. The method for forming such electrical interconnection through an organic semiconducting layer may be used in different kind of organic electrical devices. No complicated mask or photolithographic patterning is required. There is process simplification, and, in case of a light emitting device, especially a top emitting OLED, the uniformity of the emitted light is improved. By means of the laser light a kind of a via is provided through the organic layer electrically connecting the metalized areas on the opposite sides of the organic layer. Such arrangement of layers may be provided in organic light emitting devices as well as organic non light emitting devices.

Forming the interconnection with laser requires that the laser does not ablate the layers; therefore it is preferably that the laser power is lower than the power used for ablation. It is further preferable that the power of the laser is between 1 to 15 W, more preferably between 5 to 8 W, for an infrared laser with a wavelength between 800 to 10µm; for laser with shorter wavelengths in the range of 300 to 800 nm, it is preferred that the power is between 200 mW and 3 W, more preferably from 200 mW to 1 W, even more preferably from 200 to 500 mW.

It is preferred that the laser emission is between 300 and 550 nm, especially in the range between 300 and 450 nm; in these ranges, the absorption of the metal layer is stronger, and it is easier to promote a heating. Any laser can be used, preferred ones are tripled or quadrupled Nd lasers, excimer lasers, or semiconducting lasers.

Non limiting examples of such short wavelength lasers are InGaN blue-violet laser, tripled Nd:YAG, XeF excimer layer.

Optionally, the laser used for the electrical interconnection has a wavelength from 500 to 1500 µm. Exemplary lasers are Nd lasers operating in their main wavelength which is typically in the range of 1020-1050 nm, however other bands as well as the double frequency can be used. Examples of such lasers are Nd:YAG at 1064 nm or 532 nm; Nd:YVO4 at 914, 1064 or 1342 nm; Nd:YLF at 1047 or 1053 nm. Gas and excimer lasers can also be used, as well as semiconductor or fiber lasers. The laser can also match the absorption of transparent oxide layer (if such is used as electrode); it can also match an absorption wavelength of the OSL.

The method can be applied on an OLED fabricated on a metal substrate, or on a non-metallic substrate covered by a metal layer. OLEDs on metal substrate are by definition top-emitting, because the metal substrate is not transparent. In case the OLED is fabricated over a metal substrate, an electrically insulating layer (also referred herein as insulating layer) is required. The insulating layer is required to support a conductive layer without creating a short circuit, whereas the conductive layer forms the bottom electrode or is connected to the bottom or to the top electrode. The conductive layer is at least one; it can also be a plurality. Since the metal substrate or the metal layer of the non-metallic substrate is electrically connected to the OLED, the insulating layer has to be patterned. This patterning step can be made by any known method.

According to a preferred embodiment, wherein the step of fabricating the patterned insulating layer comprises steps of fabricating an insulating layer over the substrate, and patterning the insulating layer.

In another preferred embodiment, the step of patterning the insulating layer comprises a step of patterning the insulating layer by laser ablation.

In a preferred embodiment, the step of fabricating the metalized structure comprises steps of depositing a metal layer over the substrate, and patterning the metal layer.

According to a further embodiment, the step of patterning the metal layer comprises a step of patterning the metal layer by laser ablation.

In a further embodiment still, the step of fabricating the metalized structure comprises steps of depositing a layer of a photoresist material over the substrate, depositing a metal layer over the photoresist layer, and patterning the metal layer by partially removing the photoresist material. In the invention, the step of fabricating the metalized structure comprises a step of providing the region B by a metal substrate, or by the metal layer on the non-metallic material of the substrate. In still a further embodiment, the method further comprises steps of encapsulating the organic light emitting diode, and forming the electrical short between the top electrode and the feed contact by irradiation of laser light before or after the step of encapsulating the organic light emitting diode. In the latter case, the laser light is irradiated through the encapsulation fabricated before. In the alternative procedure, the laser light is irradiated prior to depositing the encapsulation.

Following, preferred embodiments are described in further detail.

For a metal substrate, the step of providing a substrate further comprises a step of fabricating a patterned insulating layer over the substrate. Alternatively the step of providing a substrate further comprises the following steps of (i) fabricating a non patterned insulating layer over the substrate, and (ii) patterning the insulating layer by removing a determined area. Here, step (ii) can be made, for example, by lift-off on an underlying photoresists, or it can be removed by laser ablation. In a preferred embodiment, the insulating layer is a photoresist, and step (ii) includes developing the photoresist and removing the determined areas.

Non-limiting examples of metal substrates are stainless steel, austenitic stainless steel, martensitic stainless steel, Aluminum alloy, 6063 Aluminum alloy, aluminum plates produced by Alanod Ltd. (UK), steel plates from Arcelor Mittal.

A current supply layer which may generally be referred to as feed contact or feed layer is necessarily deposited over the insulating layer to provide the electrical connection, later on, to the top electrode. Obviously the number of current supply layers is not limited to one. In addition, additional current supply layer(s) can be deposited over the insulating layer and/or over and in electrical and mechanical contact to the metal substrate. This additional current supply layer(s) do provide electrical connection to the OSL by forming the bottom electrode. In this embodiment, the additional layer is required to improve the reflectivity of the bottom electrode. It can also have an additional smoothing effect, especially if deposited over the insulating layer, to avoid shorts caused by the roughness of the substrate.

To simplify the fabrication, the conductive layers which form the bottom electrode and those which are connected to the top electrode are formed in parallel by the same deposition step. The conductive layers which are connected to the top electrode form the feed contacts to the top electrode. The layer is patterned, during or after deposition. This patterned layer may be referred to as SML. Non-limiting examples of the SML are: metal layers such as Cu, Ag or Al.

There are several alternatives to fabricate the SML. The step of fabricating a structured metal layer can further comprise the following steps of depositing a metal layer over the substrate, and patterning the metal layer to form the SML.

Alternatively, the substrate can be a non-metallic and non-conductive substrate. Non limiting examples of non-metallic substrates are glass and plastic substrates.

If non-metallic substrates are employed, a relatively thick conducting layer used as current distribution layer which may be referred to as CDL is to be deposited over the substrate. This CDL has a typical thickness in the range of 50 nm to 5 µm, preferentially in the range of 150 nm to 500 nm. The CDL is preferentially thicker than the top electrode.

The fabrication method of the OLED on a non-metallic substrate with a CDL is the same as the method used for a metal substrate.

For non-metallic substrates, a patterned insulating layer as described above is deposited over the CDL.

Preferentially, for non-metallic substrates, the step of providing a substrate further comprises the following steps of fabricating a metal layer (TML) over the substrate, and fabricating a patterned insulating layer over the thick metal layer.

There is a technical problem in implementing the laser interconnection process in a conventional OLED fabrication tool. In an OLED most of the layers need be processed in a highly controlled atmosphere. The addition of an intermediate step using a laser may require complicated and expensive modifications of existing tools. With the present invention it is possible to fabricate the interconnection in OLEDs which are already encapsulated. The encapsulation provides a transparent window, so that the emitted light of the OLED can escape. This same window is preferably used for the laser interconnection.

In an advanced mode of the invention, the interconnecting step is preceded by the following step of encapsulating the organic light emitting diode. It is preferred that the laser which does the electrical interconnection is irradiated through the encapsulation.

In some cases color filters, UV filters, or other layers (films) are fabricate over the encapsulation. It is preferably that the deposition of these layers is made after the electrical interconnection. The encapsulation may be a glass cover or thin film encapsulation. It is necessary that the encapsulation does not absorb the laser light (Absorption < 2%). A highly transparent encapsulation, with a transmittance > 98% to the wavelength of laser being used is preferred.

In an advanced mode of the invention, several, electrical interconnections are made to electrically connect the top electrode to the metal substrate (or to the CDL) to increase the homogeneity of large area OLEDs. The connections are made in defined areas (RB) where there is no bottom electrode, therefore the layer which defines the bottom electrode must be patterned. The connections are preferentially made with a minimum lateral distance between each other of at 5 mm to 100 mm, preferentially between 10 to 45 mm. Larger distances do not provide the required homogeneity of the light emission. Shorter distances will compromises the overall area, not due to the laser spot, which has a diameter of several µm to a few hundred µm, but due to the necessary patterning of the bottom electrode, which is much larger (diameter at least 3 times of the laser spot) than the electrical interconnection to avoid alignment problems.

A preferred method to create the interconnections on a structured SML is to deposit an unstructured SML, and pattern the SML by laser ablation.

Another preferred method to create the interconnections on a structured SML is to deposit an unstructured SML, and pattern the SML with laser ablation. In this case the step of making the electrical interconnections uses an optical alignment method: A low intensity laser (which does not modify the layers, power < 50 mW) and optical detection with feedback to the laser scanner to determine and adjust the laser position, before using the laser to create the interconnection. With the optical alignment method, the interconnection can be made smaller, because the insulating area of the SML can be very small.

It is a special advantage of the invention that all the patterning is made by laser ablation.

In an example not forming part of the invention, a glass substrate is used, there is no step of depositing an insulating layer on the glass substrate before the SML. There is also no deposition of the CDL. In this mode the SML is deposited in several regions, wherein at least 2 are not electrically short-circuited to each other. A first region is used to form the bottom electrode, or an additional conducting layer may be deposited at least partially overlapping the first region to form the bottom electrode. A second region of the SML which is not electrically connected to the first region provides the electrical connection to the top electrode, via the electrical interconnection.

Preferably, the SML is deposited directly over the glass substrate. Preferably, the SML is deposited as parallel strips, which strips do not necessarily have to be rectangular shaped.

Optionally, the strips which are electrically connected to the bottom electrode, or which form the bottom electrode, are formed to be electrically connected in parallel. The interconnection of the layer forming the top electrode and the second region of the SML is provided by the invented laser interconnection method.

In another embodiment, a serial connection is made with the laser interconnection. Here, the first region of the SML is connected or forms the bottom electrode on a first OLED and additionally the first region is connected via the electrical interconnection to a top electrode of a second OLED. The top electrode must be patterned, for example, with laser ablation, or shadow mask deposition. Preferentially three or more OLEDs are electrically connected in series by using this method.

In another advanced embodiment, the method provides an easy path for fabrication of large area OLEDs electrically connected in series. It was found that the longer operation a deposition apparatus of the top electrode, with shadow masks, very often requires maintenance, because the shadow mask accumulates too much material. A maskless deposition of the top electrode is therefore preferred.

The method includes the step of depositing a transparent conducting layer (TCL) over the OSL, wherein the deposition is essentially maskless, and further includes the following steps of (i) partially removing the metal layers to form regions, preferably stripes, which are electrically disconnected from each other, in such a way to form individual OLEDs, and (ii) making the interconnection by forming the serial connection between the individual OLEDs. Steps (i) and (ii) can be made before the encapsulation, but are preferably done after the encapsulation.

In case of a large area organic light emitting device the area of the device is preferentially larger than about 25 cm², preferentially larger than about 100 cm². Each OLED is preferentially larger than 1 cm² (the device comprises one or more OLEDs).

Following, terms used in the present specification and / or the claims are described in further detail.

Metal substrate: the metal substrate is preferentially a stainless steel or an aluminum plate. The substrate should have a low roughness, preferably a RMS roughness below half thickness of the insulating layer. It is further preferred that the stainless steel has at least one surface which is electro polished. Since the OLED is fabricated over a metal substrate, or on a metal layer of a non-metallic substrate, an electrically insulating layer is required.

The insulating layer is required to support a conductive layer without creating a short circuit, which conductive layer forms or is connected to the bottom or top electrode. The conductive layer is at least one; it can also be a plurality.

In the present application the following terms are used for describing preferred embodiments of the invention.

Patterned or structured: a layer is considered to be patterned or structured if it comprises functional geometrical features which are much smaller than the smallest substrate lateral dimension. A layer is also considered to be patterned if it comprises several disconnected areas; a non limiting example are two parallel strips which are not in direct contact to each other but are formed by the same layer.

Top electrode: The top electrode is a transparent conductive electrode. The electrode is only defined as such in the active light emitting area, which is the overlap of the three layers: bottom electrode, OSL, top electrode. The top electrode is the electrode which is more far away from the substrate; it is between the OSL and the encapsulation.

Bottom electrode: The bottom electrode is preferentially highly reflective.

Reflective: The reflection in the wavelength range corresponding to the light emitted by the OSL is greater than 85 %, preferentially greater than 95 %.

Transparent: The transmittance in the wavelength range corresponding to the light emitted by the OSL is greater than 70 %, preferentially greater than 90 %.

maskless (or essentially maskless): in this method the deposition area is defined by a shadow mask which defines only the limiting external borders of the layer, the shadow mask has an opening (a through-hole) which is defined by one close geometric shape, which can be convex or a concave, preferentially convex, more preferentially a rectangular, closed conic section, or other closed curved shape shape. A non limiting example is a rectangular frame with one rectangular opening, the one rectangular opening defines the deposition area over the whole substrate, expect for the borders, which need to be isolated, there is no further structure.

Current distribution layer: Is a layer which provides electrical connection to the top electrode, but it does not form an electrode itself. The current distribution layer may also be referred to as feed contact.

Insulating layer: the insulating layer is at least one electrical insulating layer. Optionally more than one insulating layer can be used. Non limiting examples are polyimide, PVC, polyurethane, PMMA, Aluminum oxide. A non-limiting example of a double insulating layer is: polyimide/Aluminum oxide. The thickness of the insulating layer is typically between 200 nm to 100 µm, preferentially between 200 nm and 10 µm, more preferentially between 500 nm and 7 µm. The insulating layer can also be used as a smoothing layer, to smooth out the roughness of the metal substrate. For metal substrates, the smoothing layer is preferably thicker than 1 µm.

Structured metal layer: Is the layer which forms the bottom electrode; it can extend beyond the top electrode to provide an area for the electrical connection.

Organic semiconducting layer (OSL): organic semiconducting and emitter layer, or stack of organic semiconducting layers comprising at least one emitting layer. It is a layer comprising at least one organic semiconducting layer. The OSL comprises at least one emitting layer. Typically the OSL is a stack of several organic layers, see, for example the OLED description and examples in paragraphs [0005] ("prinzipielle Aufbau"), [0023] ("Vorteilhafte Ausführung"), and [0037] ("bevorzugtes Ausführungsbeispiel") of EP 1 336 208 B1; see also US 2009/0,045,728, especially the paragraph [0078]-[0085] ("A light emitting device comprises m electroluminescent units") and examples 1 to 7 therein. The OSL can also be polymeric or hybrid, non limiting examples are described in US 2005/0,110,009 A1, especially in paragraphs [0004-0009] ("organic light-emitting diodes in the form of PLEDs"), and [0017-0025] ("p-i-n heterostructure"). Examples of top emitting OLEDs can be found in US 7,274,141, especially the advantageous embodiment in column 4, where the blocking layers are optional, that embodiment can also be of noninverted type (cathode closer to the substrate than the anode). Although these cited documents do not necessarily describe top emitting OLEDs, they describe the stack of organic layers, which stack can be applied to the electrodes described herein.

Transparent conducting layer: Is the layer which forms the top electrode; it can extend beyond the top electrode.

### Description of preferred embodiments of the invention

In the following, the invention will be described in further detail, by way of example, with reference to different embodiments. In the figures show:
Fig. 1 a method, not forming part of the invention, for providing an interconnection to a device over a metal substrate,
Fig. 2 a method, according to the invention, for providing an interconnection to a device over a metal substrate or non-conductive substrate/metal layer where the top electrode is electrically connected via the interconnection to the metal substrate or to the metal layer on the glass substrate,
Fig. 3 a method, not forming part of the invention, for providing an interconnection to a device over a non-conductive substrate,
Fig. 4 a top view of the device where interconnections are made in a line, and the OLEDs are formed as parallel strips,
Fig. 5 a top view of a possible configuration of the CDL and the insulating layer over a metal substrate, and
Fig. 6 a top view of a large area, highly homogeneous device made without mask or photolithographic patterning using laser patterning and laser interconnection.

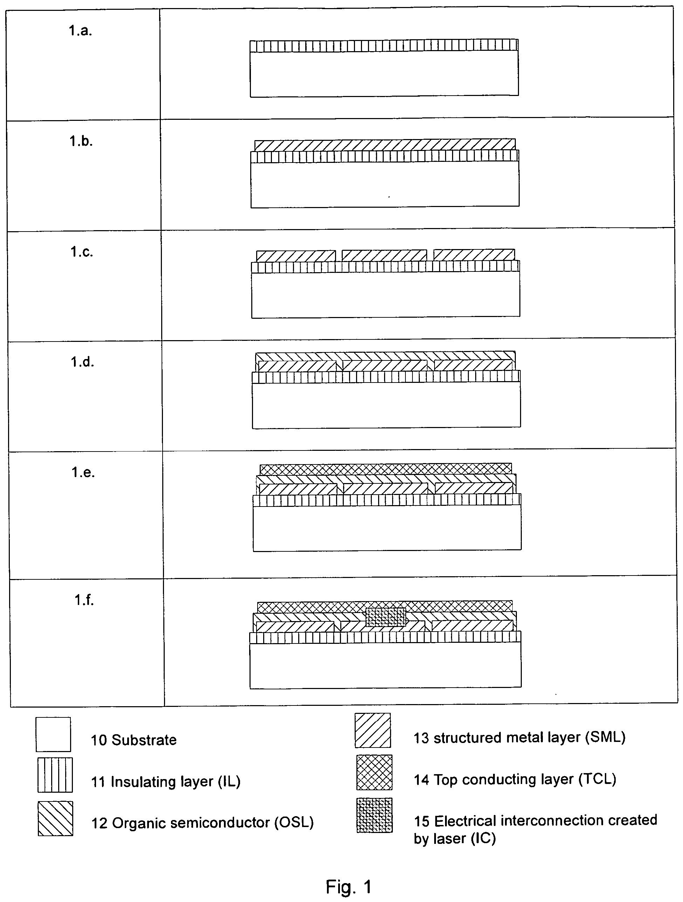

Fig. 1 shows the important steps of the method to create a light emitting device with laser interconnections. A substrate is provided.

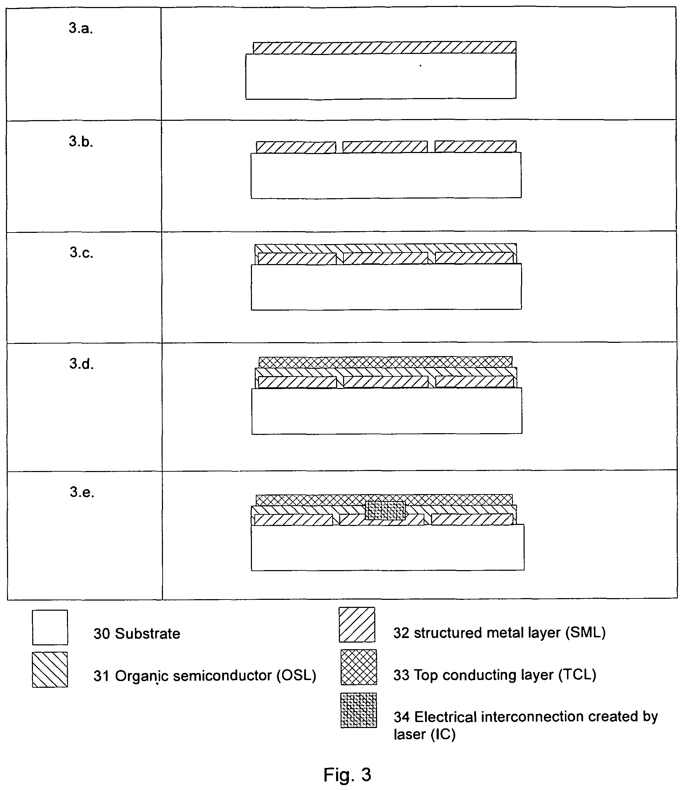

The substrate is coated with an insulating layer in a step 1.b. Preferably, the deposition is made with reactive CVD, spin coating, sputtering, VTE (vapor thermal evaporation), spray, ink-jet, or blade coating. After this step, the SML is deposited, the desired structure can be obtained by depositing the layer only on the desired areas or by depositing the layer over the whole are and by posterior patterning (1.c). Non limiting examples of such methods are shadow mask deposition by VTE, shadow mask deposition by sputtering, deposition with posterior laser patterning, deposition with posterior lift-off of an underlying patterned layer. The pattern of the SML is such that at least two, electrically disconnected regions, are formed. In Fig. 1, 3 regions can be seen from the left to the right: the region (RA) which will partially form the bottom electrode, the region B which will form the electrical connection for the top electrode, and the additional region A, which will partially form the bottom electrode of an additional light emitting diode.

On step 1.d of Fig.1, the OSL is deposited by conventional techniques. The OSL comprises: small molecules materials, small molecule layers, polymer layers, or small molecule and polymer layers. The TCL is deposited over the OSL on step 1.e. The deposition of the TCL is preferentially made by VTE or sputtering and is essentially mask-less.

The at least one electrical interconnection between SML and TCL is formed by laser on the step 1.f, electrically interconnecting the top electrode to the region (RB).

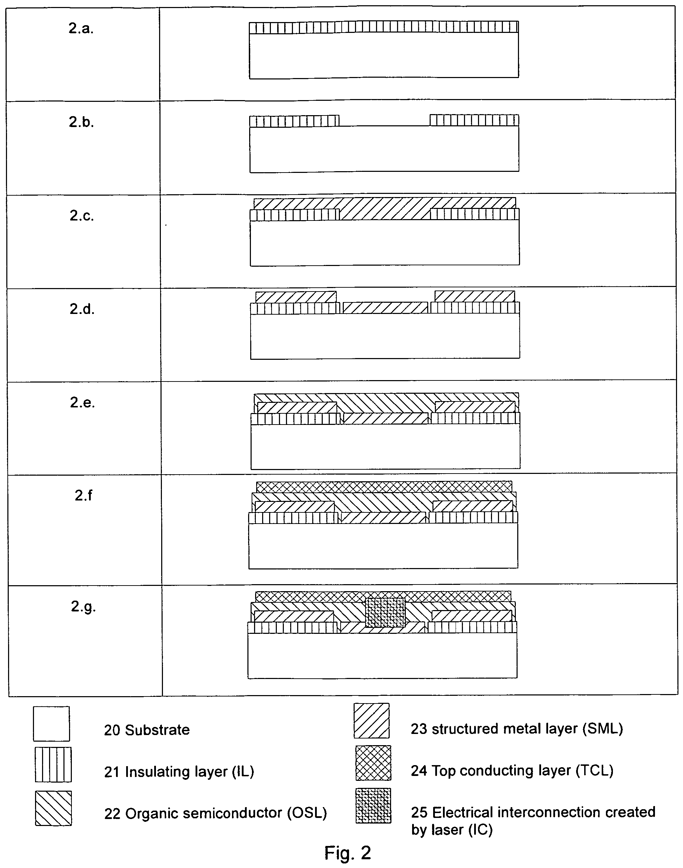

Fig. 2 shows the steps of the method to create a light emitting device with laser interconnections. This embodiment makes use of the electrical conductive properties of the substrate. A metal substrate is provided which could alternatively be a non-conductive substrate coated with a metal layer. Examples of metal substrates are given above. Non-limiting examples of coated non-conductive substrates re glass coated with aluminum, glass coated with cupper, PET (Polyethylene terephthalate) coated with cupper, polyimide coated with silver.

Step 2.a is the deposition of an insulating layer over the substrate. The deposition can be in a patterned way, optionally the deposition is unpatterned and the layer is patterned afterwards. A preferred mode is an insulating layer which is also a photoresist and can be patterned by photolithography. Another preferred mode is that the insulating layer is patterned by laser ablation.

A SML is deposited in step 2.b, also the SML needs to defined in regions (RA) and (RB) which are electrically disconnected from each other. The pattern of the SML can be defined during deposition, or it can be patterned by an additional step 2.c. The functions of regions (RA) and (RB) are the same as explained above in Fig.1.

Alternatively, the insulating layer and the SML are deposited without pattern and both layers are patterned in one step, in this case the at least one region (RB) (middle SML region in the Fig. 2, step 2.d.) is also removed. A preferred mode for patterning both layers is by lift-off in case the insulating layer is also a photoresist. Another preferred mode is that both layers are patterned by laser ablation.

Step 2.e corresponds to step 1.d of Fig. 1. Step 2.f corresponds to step 1.e of Fig. 1.

Step 2.g is the interconnecting step, in the claimed invention the electrical interconnection is directly made to the metal substrate or to the conductive layer provided on the non-conductive-substrate.

Fig. 3 shows the method on how to fabricate an organic light emitting device on a non conductive substrate. A non-conductive substrate is provided (such as glass, plastic or other). A SML is deposited over the non-conductive substrate in step 3.a, as explained in the Fig. 1 and 2, the SML, a patterning step (3.b) can optionally follow, if the SML is not deposited in a structured way.

The SML of Fig. 3 has a least 2 regions, as explained in Fig.1. Step 3.c corresponds to step 1.d of Fig. 1. Step 3.d corresponds to step 1.e of Fig. 1. Step 3.e corresponds to step 1.f of Fig. 1.

The light emitting device is powered by a power supply applying voltage between regions A and regions B.

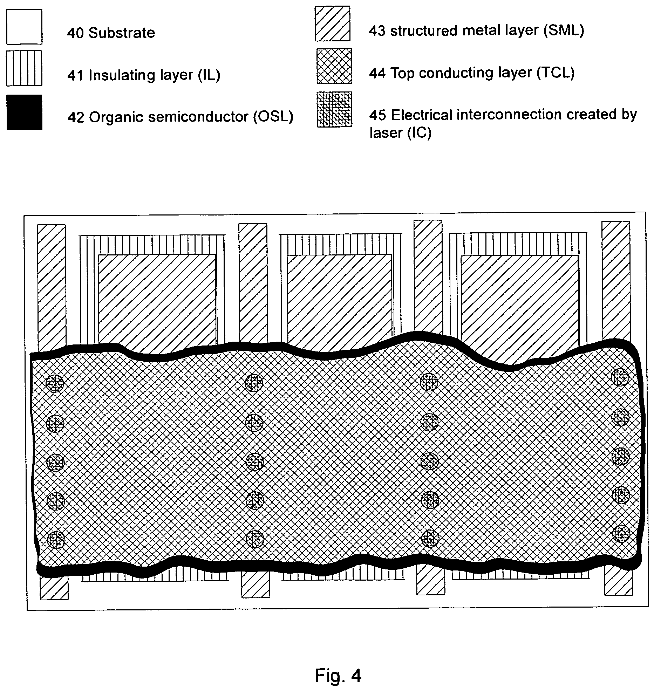

Fig. 4 is a top view of OLEDs formed as parallel strips. Fig. 4 shows a substrate 40, comprising a SML 43 structured in parallel wider and narrower areas (providing regions A and B, respectively), which wider areas are formed over the insulating layer 41. An unpatterned OSL 42 is deposited over SML 43, followed by a TCL 44 which is deposited over the OSL 42. The narrower SML areas 43 are the regions (RB) which supply current to the TCL 44 via the electrical interconnections 45. The regions (RB) are not necessary in case the substrate is a metal substrate or if the substrate is coated with a metal layer, in which case the interconnections 45 can be made directly between the TCL 44 and the substrate 40.

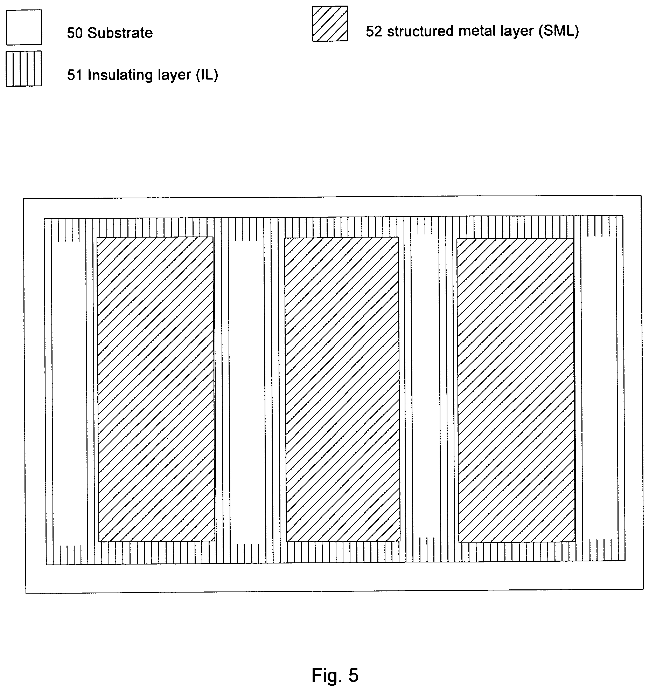

An exemplary alternative pattern for the insulating layer 51 and the SML 52 over the substrate 50 is shown in Fig. 5. Here, the substrate 50 is a metal substrate or it is a substrate coated with a metal layer. The SML 52 is only provided over the insulating layer 51. The OSL and the TCL are deposited on top (not shown). In this embodiment the interconnection of the TCL is made on the areas which do not comprise the insulating layer 51.

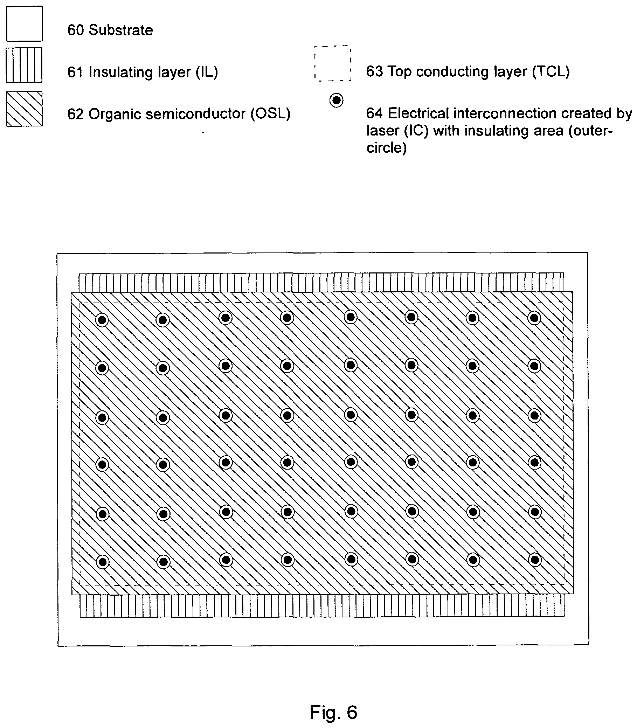

Fig. 6 shows another embodiment in which a substrate 60 is provided, the substrate 60 being a metal substrate or it is a substrate coated with a metal layer. The substrate 60 is coated with an insulating layer 61; the insulating layer 61 is patterned by forming a matrix of holes defined by the outer circle of points 64. The SML is not shown to keep the figure simple, but it is formed under the OSL 62 and it is patterned as well with holes at the same position as the insulating layer 62 (also defined by the outer circle of points 64). The TCL is deposited on the rectangular area defined by the dashed line. The interconnections are made by laser and are defined by the black (full) circles 64.

In Fig. 6 the OLED can be electrically connected to a power supply via an extension of the SML and an electrical connection to the substrate, or conductive layer on the substrate in case the substrate is non-conductive.

In all figures, it is preferred that the encapsulation is made before the interconnection step.

Following, different examples are described. If not otherwise specified, the following deposition techniques were used in the examples, below:
- SML was deposited by VTE using shadow mask for the patterning.
- OSL was deposited by VTE.
- TCL was deposited by VTE, but could be done by sputtering or other method as well.
- the interconnection step of the non-encapsulated devices was done under inert atmosphere.

### Example 1 (not forming part of the present invention): Organic light emitting device comprising electrical interconnections

A 100 mm x 100 mm glass substrate was provided. A 90 mm x 78 mm metal layer SML was deposited over the glass substrate. The metal layer is patterned forming parallel strips: wide strips (RA - region A) with the dimensions of 90 mm x 20 mm and narrow strips (RB - region B) with dimension of 90 mm x 3 mm; there is always a space of 1mm between the strips. The strips are formed in the following configuration: (RB) - 3x ((RA) - (RB)) ("-" indicates a lateral layer separation). This configuration is similar to the SML in Fig. 4.

An non-patterned 80 mm x 78 mm OSL comprising the following layers, was deposited over the SML as follows: 50 nm thick NPD layer doped with F4TCNQ; 10 nm thick non-doped NPD layer; 20 nm blue emitter host layer doped with a fluorescent emitter; 10 nm BPhen; 60 nm BPhen doped with Cs; and 20 nm Ag layer was deposited as TCL.

The overlap between the OSL, (RA), and the TCL forms the bottom electrode. (RB) is the feed contact to the top electrode.

The electrical interconnection was formed by applying laser pulses on the regions (RB); the laser was applied from the top-side (in other words, not through the substrate). The laser used in this example was a DPSS Nd:YAG laser operating at 1064 nm. The interconnecting points were fabricated over the 80 mm length of each of the regions (RB) (which length does overlap the OSL) with a linear density of 1 point / 250 µm.

Finally, for testing the device, the regions extremities of the regions (RB) (which do not overlap the OSL) where connected to the negative pole of a voltage supply and the extremities of the regions (RA) were connected to the positive pole of the voltage supply. This device was formed with 3 light-emitting regions connected in parallel, all three regions worked with a high luminance and a high homogeneity of the emitting light intensity over the emitting surface.

### Example 2 (not forming part of the present invention): Organic light emitting device on a metal substrate and electrical interconnections

A 0,8 mm thick stainless steel plate with lateral dimensions of 100 mm x 100 mm, was provided as substrate. A 2,3 µm thick polyimide layer (PI2555 from HD microsystems) was deposited on the metal substrate by spin coating at 3500 rpm and heated at 180 °C for half an hour. The steps of Example 1) were repeated (expect for the first one: providing the glass substrate). The device worked as in Example 1), as expected.

### Example 3 (not forming part of the present invention): Organic light emitting device on a metal substrate and electrical interconnections

A 0,8 mm thick stainless steel plate with lateral dimensions of 100 mm x 100 mm was provided as substrate. A 2,3 µm thick photodefineable polyimide layer (HD-8820 from HD microsystems) was deposited on the metal substrate by spin coating at 3500 rpm. The polyimide layer is heated at 120 °C for 3 minutes; the pattern is defined by exposing to a light pattern for 50 seconds, developed for 120 seconds and heated at 180 °C for half an hour. A 100 nm thick SML layer of Ag was deposited on the polyimide layer (RA) and on the exposed substrate areas (RB), as shown in Fig. 4. In this case, the feed contact is provided by the substrate itself (the areas (RB)). The steps of depositing the OSL and the TCL were repeated as in Example 1).

The electrical interconnection was formed by applying laser pulses on the regions (RB); the laser was applied from the top-side (in other words, not through the substrate). The laser used in this example was a pulsed Nd:YVO4 laser operating at 1064 nm. The interconnecting points were fabricated over the 80 mm length of each of the regions (RB) (which length does overlap the OSL) with a linear density of 1 point / 250 µm.

The method resulted in the desired effect.

### Example 4 (inventive): Organic light emitting device on a metal substrate and electrical interconnections

The Example 3 was repeated with the following modifications. The polyimide layer was patterned as in Fig. 5. The SML was not deposited in contact with the metal substrate, it was patterned to only be deposited over the polyimide layer, as the in Fig. 5.

### Example 5 (inventive): Organic light emitting device with electrical interconnections

A 0,8 mm thick stainless steel plate with lateral dimensions of 100 mm x 100 mm was provided as substrate. A 2,3 µm thick photo definable polyimide layer (HD-8820 from HD microsystems) was deposited on the metal substrate by spin coating.

The polyimide layer is heated at 120 °C for 3 minutes; the pattern is defined by exposing to a light pattern for 50 seconds, developed for 120 seconds and heated at 180 °C for half an hour. The polyimide layer is patterned to expose the substrate as a matrix of holes. The spacing between row and columns of the matrix was 20 mm, and each hole had a diameter of 1 mm. A 100 nm thick SML layer of Ag was deposited on the polyimide layer.

A frequency doubled Nd:YAG laser was used to remove the SML and the insulating layer in the holes, exposing the substrate. Alternatively the photo definable polyimide layer or an additional photoresist could be used to pattern the SML, although it increases complexity.

The steps of depositing the OSL and the TCL were repeated as in Example 1).

The electrical interconnection was formed by applying laser pulses on the center of each hole forming 3 adjacent interconnections; the laser was applied from the top-side (in other words, not through the substrate). The laser used in this example was a pulsed Nd:YAG laser operating at 1064 nm.

The method resulted in a device depicted by Fig. 6. The OLED showed a high homogeneity of the emitted light over the device's surface.

### Example 6 (inventive): Encapsulated organic light emitting device with electrical interconnections

The example 5 was repeated, however the device was encapsulated with a glass cover and step of making the electrical interconnections was done after the encapsulation, irradiating the laser through the glass cover. The advantage is that the interconnecting step could be done in air, whereas it has to be done under inert atmosphere for non-encapsulated samples, which are sensitive to oxygen, moisture, and dust.

### Example 7 (inventive): Encapsulated organic light emitting device with electrical interconnections over glass

The Example 6 was repeated, with the following modification: A glass substrate comprising a relatively thick, non-patterned, metal layer of 500 nm (TML) was used in place of the metal substrate.

### Example 8 (inventive): Organic light emitting device with maskless deposition

A 0,8 mm thick stainless steel plate with lateral dimensions of 100 mm x 100 mm was provided as substrate. A 2,3 µm thick polyimide layer (PI2555 from HD microsystems) was deposited on the metal substrate by spin coating at 3500 rpm and heated at 180 °C for half an hour. A 100 nm thick SML layer of Ag was deposited on the polyimide layer.

Holes were made in the polyimide layer and the SML were patterned using a Nd:YAG laser to ablate both layer at once.

The steps of depositing the OSL and the TCL were repeated as in Example 1), essentially unpatterned but with defining an area such that electrical connections from a power supply could be made to the electrodes.

The electrical interconnection was formed by applying laser pulses on the center of each hole forming the interconnections; the laser was applied from the top-side (in other words, not through the substrate) using optical alignment (however it could be made without optical alignment). The interconnections were made 1 / mm in a matrix format.

The OLED worked as expected with a very high homogeneity. With this highly simplified method it was possible to make a large area light emitting organic device without any mask or lithographic patterning step.

Other lasers were also tested, and the parameters for each different laser can be easily adjusted to provide the interconnection.

The description does not aim to exhaust all the possible variations of the invention. The skilled in the art would easily realize modifications and adaptations. For example, although it is not the preferred mode, the area covered by the TCL can extend over the area of the OSL providing an additional electrical contact to the conductor which supplies its current (e.g. to the metal substrate).

## Claims

1. A method of forming a top-emitting organic light emitting diode, the method comprising the steps in the following order of:
- providing a substrate, wherein the substrate is made of a metallic material or a non-metallic material covered by a metal layer,
- fabricating a patterned insulating layer on the substrate,
- fabricating a metalized structure, the metalized structure comprising a region A being formed over the insulating layer and providing a bottom electrode and a region B being formed by the metallic material of the substrate or by the metal layer on the non-metallic material of the substrate and providing a feed contact for a top electrode, wherein the regions A and B are electrically disconnected from each other,
- depositing an organic semiconducting layer over the metalized structure,
- depositing a transparent conducting layer over the organic semiconducting layer thereby providing the top electrode, and
- forming an electrical short between the top electrode and the feed contact in a connecting area by electrically interconnecting the top electrode with the feed contact through the organic semiconducting layer by irradiating laser light into the connecting area.

2. The method according to claim 1, wherein the step of fabricating the patterned insulating layer comprises steps of:
- fabricating an insulating layer over the substrate, and
- patterning the insulating layer.

3. The method according to claim 2, wherein the step of patterning the insulating layer comprises a step of patterning the insulating layer by laser ablation.

4. The method according to one of the preceding claims, wherein the step of fabricating the metalized structure comprises steps of:
- depositing a metal layer over the substrate, and
- patterning the metal layer.

5. The method according to claim 4, wherein the step of patterning the metal layer comprises a step of patterning the metal layer by laser ablation.

6. The method according to one of the preceding claims, wherein the step of fabricating the metalized structure comprises steps of:
- depositing a layer of a photoresist material over the substrate,
- depositing a metal layer over the photoresist layer, and
- patterning the metal layer by partially removing the photoresist material.

7. The method according to one of the preceding claims, the method further comprising steps of:
- encapsulating the organic light emitting diode, and
- forming the electrical short between the top electrode and the feed contact by irradiation of laser light before or after the step of encapsulating the organic light emitting diode.

## Patentansprüche

1. Verfahren zum Herstellen einer top-emittierenden organischen lichtemittierenden Diode, wobei das Verfahren die folgenden Schritte in der folgenden Reihenfolge umfasst:
- Bereitstellen eines Substrats, wobei das Substrat aus einem metallischen Material oder aus einem nicht-metallischem Material, das mit einer Metallschicht bedeckt ist, gebildet ist,
- Bilden einer strukturierten isolierenden Schicht auf dem Substrat,
- Bilden einer metallisierten Struktur, welche einen Abschnitt A und einen Abschnitt B umfasst, wobei der Abschnitt A über der isolierenden Schicht gebildet ist und eine Grundelektrode bereitstellt, und wobei der Abschnitt B mittels des metallischen Materials des Substrats oder mittels der Metallschicht auf dem nicht-metallischen Material des Substrats gebildet ist und einen Zuführungskontakt für eine Top-Elektrode bereitstellt,
wobei die Abschnitte A und B elektrisch voneinander isoliert sind,
- Abscheiden einer organischen halbleitenden Schicht über der metallisierten Struktur,
- Abscheiden einer transparenten leitfähigen Schicht über der organischen halbleitenden Schicht zum Bereitstellen einer Top-Elektrode und
- Ausbilden eines elektrischen Kurzschlusses zwischen der Top-Elektrode und dem Zuführungskontakt in einem Verbindungsbereich, indem die Top-Elektrode mit dem Zuführungskontakt mittels Einstrahlen von Laserlicht durch die organische halbleitende Schicht in dem Verbindungsbereich elektrisch verbunden wird.

2. Verfahren nach Anspruch 1, wobei das Bilden der strukturierten isolierenden Schicht folgende Schritte umfasst:
- Bilden einer isolierenden Schicht über dem Substrat und
- Strukturieren der isolierenden Schicht.

3. Verfahren nach Anspruch 2, wobei das Strukturieren der isolierenden Schicht eine Strukturierung der isolierenden Schicht mittels Laserablation umfasst.

4. Verfahren nach einem der vorangehenden Ansprüche, wobei das Bilden der metallisierten Struktur folgende Schritte umfasst:
- Abscheiden einer Metallschicht über dem Substrat und
- Strukturieren der Metallschicht.

5. Verfahren nach Anspruch 4, wobei das Strukturieren der Metallschicht ein Strukturieren der Metallschicht mittels Laserablation umfasst.

6. Verfahren nach einem der vorangehenden Ansprüche, wobei das Bilden der metallisierten Struktur folgende Schritte umfasst:
- Abscheiden einer Schicht aus einem Photolack über dem Substrat,
- Abscheiden einer Metallschicht über der Photolackschicht und
- Strukturieren der Metallschicht mittels teilweisem Entfernen des Photolacks.

7. Verfahren nach einem der vorangehenden Ansprüche, weiter umfassend:
- Verkapseln der organischen lichtemittierenden Diode und
- Bilden eines elektrischen Kurzschlusses zwischen der Top-Elektrode und dem Zuführungskontakt mittels Einstrahlen von Laserlicht vor oder nach dem Verkapseln der organischen lichtemittierenden Diode.

## Revendications

1. Procédé de formage d'une diode électroluminescente organique, ce procédé comprenant les étapes consistant dans l'ordre suivant à :
- prévoir un substrat, le substrat étant composé d'un matériau métallique ou d'un matériau non métallique recouvert d'une couche métallique,
- fabriquer une couche isolante modélisée sur le substrat,
- fabriquer une structure métallisée, la structure métallisée comprenant une zone A formée sur la couche isolante et prévoir une électrode inférieure et une zone B étant formée par le matériau métallique du substrat ou par la couche métallique appliquée sur le matériau non métallique du substrat et créant un contact d'alimentation pour une électrode supérieure, les zones A et B étant déconnectées électriquement l'une de l'autre,
- dépôt d'une couche semiconductrice organique sur la structure métallisée,
- dépôt d'une couche conductrice transparente sur la couche semiconductrice organique en créant ainsi l'électrode supérieure, et
- formage d'un raccourci électrique entre l'électrode supérieure et le contact d'alimentation dans une zone de connexion en connectant électriquement l'électrode supérieure avec le contact d'alimentation par l'intermédiaire de la couche semiconductrice organique en irradiant de la lumière laser dans la zone de connexion.

2. Procédé selon la revendication 1, dans lequel l'étape de fabrication de la couche isolante modélisée comprend les étapes de :
- fabrication d'une couche isolante sur le substrat, et
- modélisation de la couche isolante.

3. Procédé selon la revendication 2, dans lequel l'étape de modélisation de la couche isolante comprend une étape de modélisation de la couche isolante par ablation au laser.

4. Procédé selon l'une quelconque des revendications précédentes, dans lequel l'étape de fabrication de la structure métallisée comprend les étapes de :
- dépôt d'une couche métallique sur le substrat, et
- modélisation de la couche métallique.

5. Procédé selon la revendication 4, dans lequel l'étape de modélisation de la couche métallique comprend une étape de modélisation de la couche métallique par ablation au laser.

6. Procédé selon l'une quelconque des revendications précédentes, dans lequel l'étape de fabrication de la structure métallisée comprend les étapes de :
- dépôt d'une couche de matière photorésistante sur le substrat,
- dépôt d'une couche métallique sur la couche photorésistante, et
- modélisation de la couche métallique par enlèvement partiel de la matière photorésistante.

7. Procédé selon l'une quelconque des revendications précédentes, ce procédé comprenant en outre les étapes :
- d'encapsulation de la diode électroluminescente organique,
- de formage du raccourci électrique entre l'électrode supérieure et le contact d'alimentation par irradiation de lumière laser avant ou après l'étape d'encapsulation de la diode électroluminescente organique.
